# EUROPEAN PATENT APPLICATION

(11) **EP 1 253 155 A1**
(43) Date of publication of application: **30.10.2002**
(21) Application number: 01110473.4
(22) Date of filing: 27.04.2001
(51) Int. Cl.: C08F 2/50, G03F 7/029, G03F 7/031

(54) **Photo-initiator compositions**

(71) Applicant: UCB S.A., 1070 Bruxelles (BE)
(72) Inventor: Weissman, Peter, Marietta, GA 30066 (US)
(74) Representative: Kirk, Martin

(57) **Abstract**

Photo-initiator blends suitable for radiation curable ink formulations are disclosed which comprise a mixture of three or more photo-initiators, said mixture being a liquid at a temperature at or below ambient; the mixture comprising:
(a) a first photo-initiator comprising an optionally substituted hydroxyC₁₋₁₀ alkylC₆₋₁₈aryl ketone which is liquid at ambient temperature;
(b) a second photo-initiator comprising an optionally substituted hydroxy(cycloC₃₋₁₀alkyl)C₆₋₁₈aryl ketone which is solid at ambient temperature; and
(c) a third photo-initiator comprising an optionally substituted C₆₋₁₈aryl(((C₁₋₁₀ alkyl)₁₋₄C₆₋₁₈arylcarbonyl))₁₋₃ phosphine oxide which is solid at ambient temperature; where
   (i) the first photo-initiator (a) and the second photo-initiator (b) are present in the mixture in a weight ratio of from about 0.8 to about 1.2,
   (ii) the first photo-initiator (a) and the second photo-initiator (b) together comprise at least about 60% by weight of the total mixture; and
   (iii) the third photo-initiator (c) comprises at least about 25 % by weight of the total mixture. Inks comprising such photo-initiator blends are also described.

## Description

The present invention relates to improved liquid compositions which have use for example as photo-initiators, such as in inks suitable for use with radiation cured polymers.

Inks for use in radiation cured polymers require a photo-initiator to aid the start of polymerisation. It is often necessary or desirable to blend different photo-initiators together in a mixture to improve the sensitive of the photo-initiator over a wide range of different wavelengths so the resultant ink can be more readily cured using incident radiation comprising many different wavelengths.

In general, liquid photo-initiators and blends thereof are more convenient to use. Prior art photo-initiator blends are prepared by blending at high temperatures in an oven to keep the mixture liquid. However this is difficult to do and can causes the resultant photo-initiator blends to be less stable (i.e. solid precipitates may form when the photo-initiator is left for extended periods) . It would be desirable to provide photo-initiator compounds and/or blends with improved stability; which are substantially liquid at ambient temperatures or lower, which can be mixed together more readily that prior art blends; which are easier to use and/or which can be shipped more easily

Surprisingly the applicant has discovered that certain synergistic mixtures of photo-initiators form liquid blends which overcome some or all of the disadvantages described herein.

Therefore broadly in accordance with the present invention there is provided a mixture of three or more photo-initiators, said mixture being a liquid at a temperature at or below ambient; the mixture comprising:
(a) a first photo-initiator comprising an optionally substituted hydroxyC₁₋₁₀ alkylC₆₋₁₈aryl ketone which is liquid at ambient temperature;
(b) a second photo-initiator comprising an optionally substituted hydroxy(cycloC₃₋₁₀alkyl)C₆₋₁₈aryl ketone which is solid at ambient temperature; and
(c) a third photo-initiator comprising an optionally substituted C₆₋₁₈aryl(((C₁₋₁₀ alkyl)₁₋₄C₆₋₁₈arylcarbonyl))₁₋₃ phosphine oxide which is solid at ambient temperature;
   where
   (i) the first photo-initiator (a) and the second photo-initiator (b) are present in the mixture in a weight ratio of from about 0.8 to about 1.2,
   (ii) the first photo-initiator (a) and the second photo-initiator (b) together comprise at least about 60% by weight of the total mixture; and
   (iii) the third photo-initiator (c) comprises at least about 25 % by weight of the total mixture.

Preferably ambient temperature denotes a temperature of 20°C.

Preferably the first photo-initiator (a) comprises hydroxyC₁₋₆alkylC₆₋₁₂aryl ketone, more preferably hydroxyC₁₋₄ alkyl phenyl ketone; most preferably 2-hydroxy-2-methyl-1 -phenyl-1-propanone (such as that available commercially from CIBA as a clear liquid under the trade name "Darocur 1173").

Preferably the second photo-initiator (b) comprises hydroxy(cycloC₃₋₆alkyl)C₆₋₁₂aryl ketone; mor preferbaly hydroxy(cycloC₃₋₆alkyl)phenyl ketone; most preferably 1-hydroxycyclohexyl phenyl ketone (such as that available commercially from CIBA as a white solid under the trade name "Irgacure 184").

Preferably the third photo-initiator (c) comprises C₆₋₁₂aryl(((C₁₋₆alkyl)₂₋₃C₆₋₁₂arylcarbonyl))₁₋₂ phosphine oxide; more preferably phenyl((C₁₋₄alkyl)₃benzoyl)₂ phosphine oxide; most preferably phenyl bis(2,4,6-trimethyl benzoyl) phosphine oxide (such as that available commercially from CIBA as a solid under the trade name "Irgacure 819").

Preferably the weight ratio of the first photo-initiator (a) to the second photo-initiator (b) is from about 0.9 to about 1;1, more preferably is about 1.0.

Preferably the first photo-initiator (a) and the second photo-initiator (b) together comprise from about 60% to about 75% by weight of the total mixture.

Preferably the third photo-initiator (c) comprises from about 25% to about 40% by weight of the total mixture.

The terms 'optional substituent' and/or 'optionally substituted' as used herein (unless followed by a list of other substituents) signifies the one or more of following groups (or substitution by these groups): carboxy, sulpho, formyl, hydroxy, amino, imino, nitrilo, mercapto, cyano, nitro, methyl, methoxy and/or combinations thereof. These optional groups include all chemically possible combinations in the same moiety of a plurality (preferably two) of the aforementioned groups (e.g. amino and sulphonyl if directly attached to each other represent a sulphamoyl radical). Preferred optional substituents comprise: carboxy, sulpho, hydroxy, amino, mercapto, cyano, methyl and/or methoxy.

The term 'hydrocarbo' may also be used herein to replace other terms such as alkyl or aryl herein where the context allows. A hydrocarbo group denotes any univalent or multivalent moiety (optionally attached to one or more other moieties) which consists of one or more hydrogen atoms and one or more carbon atoms and may comprise saturated, unsaturated and/or aromatic moieties. Hydrocarbo groups may comprise one or more of the following groups. Hydrocarbyl groups comprise univalent groups formed by removing a hydrogen atom from a hydrocarbon. Hydrocarbylene groups comprise divalent groups formed by removing two hydrogen atoms from a hydrocarbon the free valencies of which are not engaged in a double bond. Hydrocarbylidene groups comprise divalent groups (represented by "R₂C=") formed by removing two hydrogen atoms from the same carbon atom of a hydrocarbon, the free valencies of which are engaged in a double bond. Hydrocarbylidyne groups comprise trivalent groups (represented by "RC≡"), formed by removing three hydrogen atoms from the same carbon atom of a hydrocarbon the free valencies of which are engaged in a triple bond. Hydrocarbo groups may also comprise saturated carbon to carbon single bonds; unsaturated double and/or triple carbon to carbon bonds (e.g. alkenyl, and/or alkynyl groups respectively) and/or aromatic groups (e.g. aryl) and where indicated may be substituted with other functional groups.

The term 'alkyl' or its equivalent (e.g. 'alk') as used herein may be readily replaced, where appropriate and unless the context clearly indicates otherwise, by terms encompassing any other hydrocarbo group such as those described herein (e.g. comprising double bonds, triple bonds, aromatic moieties (such as respectively alkenyl, alkynyl and/or aryl) and/or combinations thereof (e.g. aralkyl) as well as any multivalent hydrocarbo species linking two or more moieties (such as bivalent hydrocarbylene radicals e.g. alkylene).

Any radical group or moiety mentioned herein (e.g. as a substituent) may be a multivalent or a monovalent radical unless otherwise stated or the context clearly indicates otherwise (e.g. a bivalent hydrocarbylene moiety linking two other moieties). However where indicated herein such monovalent or multivalent groups may still also comprise optional substituents. A group which comprises a chain of three or more atoms signifies a group in which the chain wholly or in part may be linear, branched and/or form a ring (including spiro and/or fused rings). The total number of certain atoms is specified for certain substituents for example C_{1-N}hydrocarbo, signifies a hydrocarbo moiety comprising from 1 to N carbon atoms. In any of the formulae herein if one or more substituents are not indicated as attached to any particular atom in a moiety (e.g. on a particular position along a chain and/or ring) the substituent may replace any H and/or may be located at any available position on the moiety which is chemically suitable or effective.

Unless the context clearly indicates otherwise, as used herein plural forms of the terms herein are to be construed as including the singular form and vice versa.

The term "comprising" as used herein will be understood to mean that the list following is non-exhaustive and may or may not include any other additional suitable items, for example one or more further feature(s), component(s), ingredient(s) and/or substituent(s) as appropriate.

The term 'effective' and/or "suitable" (for example with reference to the processes, uses, products, materials, formulations, compositions, compounds, monomers, oligomers, polymer precursors and/or polymers used in and/or of the present invention) will be understood to denote utility in any one or more of the following uses and/or applications: preparation and/or use of radiation curable formulations, such as inks, and/or photo-initiators for use with such formulations.

Such utility may be direct where the material has the required properties for the aforementioned uses and/or indirect where the material has use as a synthetic intermediate and/or diagnostic tool in preparing materials of direct utility. As used herein the term "suitable" also denotes that a functional group is compatible with producing an effective product.

The substituents on a repeating unit in any polymers herein may be selected to improve the compatibility of the materials with the polymers and/or resins in which they may be formulated and/or incorporated for the aforementioned uses. Thus, the size and length of the substituents may be selected to optimise the physical entanglement or interlocation with the resin or they may or may not comprise other reactive entities capable of chemically reacting and/or cross-linking with such other resins.

Certain moieties, species, groups, repeat units, compounds, oligomers, polymers, materials, mixtures, compositions and/or formulations which comprise and/or are used in some or all of the invention as described herein may exist as one or more different forms such as any of those in the following non exhaustive list: stereoisomers (such as enantiomers (e.g. E and/or Z forms), diastereoisomers and/or geometric isomers); tautomers (e.g. .keto and/or enol forms), conformers, salts, zwitterions, complexes (such as chelates, clathrates, interstitial compounds, ligand complexes, organometallic complexes, non-stoichiometric complexes, solvates and/or hydrates); isotopically substituted forms, polymeric configurations [such as homo or copolymers, random, graft or block polymers, linear or branched polymers (e.g. star and/or side branched), cross-linked and/or networked polymers, polymers obtainable from di and/or tri-valent repeat units, dendrimers, polymers of different tacticity (e.g. isotactic, syndiotactic or atactic polymers)]; polymorphs (such as interstitial forms, crystalline forms and/or amorphous forms), different phases, solid solutions; combinations thereof and/or mixtures thereof. The present invention comprises and/or uses all such forms which are effective.
In another aspect of the present invention provides a composition and/or formulation obtained and/or obtainable by any of the processes of the invention as described herein.

A further aspect of the invention comprises a method of preparing an ink comprising the steps of mixing a composition and/or formulation of the invention as described herein with a suitable carrier medium and/or grinder.

A still other aspect of the present invention provides an ink obtained and/or obtainable by the preceding method. Preferred inks are those suitable for use in lithographic printing for example for graphic art applications.

A still further aspect of the invention provides use of a composition and/or formulation of the invention to make an ink, preferably a lithographic ink.

A another further aspect of the invention provides use of a ink of the invention (preferably a lithographic ink) to print an article and/or an article so printed.

Other aspects of the present invention may be given in the claims.

The invention will now be illustrated by the following non-limiting examples and tests which are by way of illustration only. Unless otherwise indicated herein all the test results and properties herein were performed using conventional methods well known to those skilled in the art.

The following ingredients are used in the Examples herein:
2-Hydroxy-2-methyl-1-phenyl-1-propanone (CAS no. 7473-98-5) which is a photo-initiator available commercially from CIBA as a clear liquid under the trade name "Darocur 1173".
1-Hydroxycyclohexyl phenyl ketone (CAS no. 947-19-3) which is a photo-initiator available commercially from CIBA as a white solid under the trade name "Irgacure 184".
Phenyl bis(2,4,6-trimethyl benzoyl) phosphine oxide (CAS no. 162881-26-7) which is a photoinitiator available commercially from CIBA as a solid under the trade name "Irgacure 819".
2-Benzyl-2-(dimethylamino)-1-[4-(4-morpholinyl) phenyl}-1-butanone (CAS no. 119313-12-1) which is a photo-initiator available commercially from CIBA as a yellow solid under the trade name "Irgacure 369".
Ethyl 4-dimethylaminobenzoate (CAS no. 10287-53-3) which is a photo-initiator available commercially as a white solid under the trade name "Quanticure EPD".
2-Isopropylthioxanthone (CAS no. 5495-84-1) which is a photo-initiator available commercially as a yellow solid under the trade name "Quanticure ITX".
TMPEOTA which denotes trimethylolpropane ethoxy triacrylate (CAS no. 28961-43-5) also known as poly(oxy-1,2-ethanediyl), alpha.-hydro-omega.-[(1-oxo-2-propenyl)oxy],-ether with 2-ethyl-2-(hydroxymethyl)-1 ;3-propanediol (3:1).
DPGDA which denotes dipropylene glycol diacrylate (CAS no. 57472-68-1) also known as 2-propenoic acid, oxvbis(methyl-2,1-ethanediyl) ester.
BDK which denotes a benzil dimethyl ketal of formula 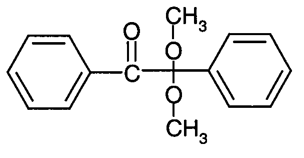 which is a solid photo-initiator suitable for UV-curable unsaturated polyester and acrylate based coatings and is available commercially from, for example, ChemFirst Fine Chemicals.
Benzophenone (CAS no. 119-61-9) is a known photo-initiator available commercially from UCB Chemicals as a white solid under the trade name "Ebecryl BPO".
MEHQ which denotes methyl hydroquinone (CAS no. 150-76-5), an inhibitor also known as the monomethyl ether of hydroquinone, available commercially from Aldrich Chemicals.
Acrylated polyester polymer having an average of 5 to 6 acrylate groups per molecule which is available commercially from UCB Chemicals under the trade mark Ebecryl 870.
Polyester acrylate oligomer grinding vehicle for flexographic ink which is available commercially from UCB Chemicals under the trade mark Ebecryl 812.
Carbon black pigment available commercially from Columbian Chemicals under the trade name Raven 450.
Copper phthalocyanine colorant available commercially from Ciba, under the trade name Irgalite Blue LGLD.
Magenta colorant available commercially from Ciba, under the trade name Irgalite Rubine L4BD.
Yellow colorant available commercially from Ciba under the trade name Irgalite Yellow BAW.

Various liquid photo-initiator blends were prepared by mixing the components according to Table 1.

**Table 1**

| (photo-initiator blends) | | | | | | | | |
|---|---|---|---|---|---|---|---|---|
| Components (%) | Ex 1 | Ex 2 | Ex 3 | Ex 4 | Ex 5 | Ex 6 | Comp A | Comp B |
| Darocur 1173 | 37.5 | 32 | 31.5 | 31 | 30.5 | 30 | 27.5 | 25 |
| Irgacure 184 | 37.5 | 32 | 31.5 | 31 | 30.5 | 30 | 27.5 | 25 |
| Irgacure 819 | 25.0 | 36 | 37 | 38 | 39 | 40 | 45 | 50 |

Examples 1 to 6 were prepared on Day 1 by blending the components together in the amounts given in Table 1, and each example was placed in a refrigerator on Day 2. The examples were then observed for stability i.e. for the presence of solid precipitates. The examples were transferred into a freezer at 11:00 am on day 14 (i.e. between observations 14(a) and 14(b)). The examples were removed from the freezer on day 23 when the experiment was ended. The observations made are given in Tables 2A and 2B for Examples 2 to 6 (Example 1 was not tested) and comparative examples Comp A and B. It can be seen that the blends were unsatisfactorily where the Irgacure 819 was present in an amount of 45% by weight or greater as significant crystallization was observed from 14 days onwards during the test (Comp A & B). In comparison Examples 2 to 6 show none or minimal crystallization during the test indicating excellent to good long tern stability.

Although the liquid Darocur 1173 is well known to be a good solvent previously it has only been possible to solubilize 20% by weight of other photo-initiators therein such as the Irgacure 819 phosphine oxide. Surprisingly it has been found that adding an approximately equal amount by weight of the solid Irgacure 184 leads to a mixture with synergistic and unexpected properties as the new mixture is capable of solubilizing 25% or more of other photo-initiators such as the Irgacure 819 (as shown in Tables 2A to 2B). In the Tables 2A & 2B a check mark indicates no solid precipitates were observed i.e. the blend was stable.

**Table 2A**

| Day | Ex 2 | Ex 3 | Ex 4 | Ex 5 | Ex 6 | Comp A | Comp B |
|---|---|---|---|---|---|---|---|
| 3 | √ | √ | √ | √ | √ | √ | √ |
| 7 | √ | √ | √ | One tiny speck at bottom of jar | √ | Almost unnoticeable flakes | Beginning crystalln. |
| 8 | √ | √ | √ | One speck at bottom of jar | √ | Slightly hazy, flakes | Beginning crystalln. |
| 9 | √ | √ | √ | One speck at bottom of jar | √ | Potential crystalln. Occurring | Beginning crystalln. few spec at bottom of jar |
| 10 | √ | One tiny speck at bottom of jar | √ | One speck at bottom of jar | √ | Potential crystalln. occurring | Beginning crystalln.; a few tiny specks settled on the bottom of jar |
| 11 | √ | One tiny speck at bottom of jar | One tiny speck at bottom of jar | Speck at bottom of jar | √ | Potential crystalln. occurring | Beginning crystalln.; a few tiny specks settled at the bottom of jar |

**Table 2B**

| Day | Ex 2 | Ex 3 | Ex 4 | Ex 5 | Ex 6 | Comp A | Comp B |
|---|---|---|---|---|---|---|---|
| 14 (a) | √ | One tiny crystal forming | One minute speck | Crystal forming obvious speck | √ | Potentially starting to crystallize throughout | Several crystals settling on bottom only |
| 14 (b) | √ | One tiny crystal forming | One minute speck | Crystal forming larger speck | √ | Potentially starting to crystallize throughout | Several crystals settling on bottom only |
| 15 | √ | One tiny crystal forming | One minute speck | Crystal forming larger speck | √ | Potentially starting to crystallize throughout | Several crystals settling on bottom only |
| 16 | √ | One tiny crystal forming | One minute speck | Crystal forming larger speck | √ | Potentially starting to crystallize throughout | Several crystals settling on bottom only |
| 17 | √ | One tiny crystal forming | One minute speck | Crystal forming; larger speck | √ | Potentially starting to crystallize throughout | Several crystals settling on bottom only |
| 22 | Perfect | 2-3 specks crystallin. occurring | One extremely hard to identify spec. Possibly beginning crystalln. | One obvious spec crystalln. has begun | Clear, however the appearance of air bubbles or minute specks. | Crystallized, not good | Multiple specs on bottom, crystalln. has begun. |

The performance of photo-initiator blends of the present invention for dark colour systems was compared to conventional photo-initiators.

Various conventional pigment concentrates (Examples B to D) were prepared as follows and with reference to Table 3. Ebecryl 812 was manually blended with pigment at a 30% level, then was continuously passed through a three-roll mill to make a pigment concentrate having a desired Hegman grind value.

**Table 3**

| Pigment Concentrates. | | | | |
|---|---|---|---|---|
| Component | Ex C Weight % / g | Ex D Weight % / g | Ex E Weight % / g | Ex F Weight % / g |
| Ebecryl 812 | 70.0% / 140.0g | 70.0% /140.0g | 70.0% /140.0g | 70.0% /140.0g |
| Carbon Black Raven 450 | 30.0% / 60.0g | --- | --- | --- |
| Irgalite Blue LGLD | --- | 30.0% / 60.0g | --- | --- |
| Irgalite Rubine L4BD | --- | --- | 30.0% / 60.0g | --- |
| Irgalite Yellow BAW | --- | --- | --- | 30.0% / 60.0g |

For comparison a formulation of the invention (Example 7, see Table 4) using liquid photo-initiator blends of the invention and a prior art formulation (Comp G, see Table 5) using a conventional liquid photo-initiator were each used as letdown vehicles (diluent formulations) to make inks. In table 4 "Liquid PI system" denotes any one of the liquid photo-initiator blends of the invention given in Examples 1 to 6 herein.

Each diluent was added at 50% to the pigment concentrations in Table 3 and was manually blended together and then dispersed for 15 minutes using the Premier Mill Dispersator to make a final ink. The final ink compositions are given in Table 6.

**Table 4**

| (Example 7) | |
|---|---|
| Components | Weight (% / g) |
| TMPEOTA | 59.9 / 269.6 |
| DPGDA | 24.0 / 108.0 |
| Liquid PI system | 16.0 / 72.0 |
| MEHQ | 0.1 / 0.45 |

**Table 5**

| (Comp G). | |
|---|---|
| Components | Weight (%) |
| TMPEOTA | 59.9 |
| DPGDA | 24.0 |
| Iragcure-369 | 2.5 |
| Quanticure EPD | 2.5 |
| Quanticure ITX | 2.5 |
| BDK | 2.5 |
| MEHQ | 0.1 |

**Table 6**

| (Ink formulations.) | | | | | | | |
|---|---|---|---|---|---|---|---|
| Components | Ex H | Ex 8 | Ex J | Ex 9 | Ex K | Ex 10 | Ex L |
| Pigment Ex A | 50.0 | --- | --- | --- | --- | --- | --- |
| Pigment Ex B | --- | 50.0 | 50.0 | --- | --- | --- | --- |
| Pigment Ex C | --- | --- | --- | 50.0 | 50.0 | | |
| Pigment Ex D | --- | --- | --- | --- | --- | 50.0 | 50.0 |
| Diluent Ex 7 | --- | 50.0 | --- | 50.0 | --- | 50.0 | --- |
| Diluent Comp G | 50.0 | --- | 50.0 | --- | 50.0 | --- | 50.0 |

The viscosities of the final inks were measured twenty-four hours after preparation using the Haake RS150 RheoStress rheometer These inks were drawn down onto a polypropylene substrate (applied on outside & wiped with isopropyl) using a Cavanagh proofer and UV cured using the fusion unit equipped with one lamp (600 WPI) 75%, 100 RPM at 190.3 mJ/cm². The ink coatings were shiny and were examined for color, adhesion and other properties. The results indicate that inks containing the photo-initiator blends of the invention perform comparably to the prior art, with few major differences in the physical properties or the performance. The blends of the invention are easier to prepare and use.

The following two photo-initiator blends of the invention (Examples 11 and 12) were identified from solubility data as of special use for inks with dark colors.

Example 11 is a photo-initiator blend of the invention comprising Quantacure EPD, Ebecryl BPO, Irgacure 369, Irgacure 184, Quantacure ITX, and Darocur 1173; and

Example 12 is a photo-initiator blend of the invention comprising Quantacure EPD, Irgacure 369, Irgacure 184, Quantacure ITX, and Darocur 1173 (i.e. without the Ebecryl EPO).

Control formulations were made comprising the photo-initiator blends of Examples 11 or 12 with an acrylated polyester polymer having an average of 5 to 6 acrylate groups per molecule (available commercially from UCB Chemicals under the trade mark Ebecryl 870). These formulations were evaluated for reactivity and lithographic properties

Inks in various colors and black were prepared by adding the photo-initiator blends of Examples 11 and 12 in amounts of 10% and 12% by weight of the ink. In addition to reactivity, basic lithographic properties such as tack and water balance were also measured. The results are given in Table 7 below where Comp M denotes a magenta ink of a similar formulation containing 10% of a conventional photo-initiator. Tack was measured using a Thwing-Albert Electronic Inkometer for 3 minutes at 1200 rpm and at a temperature of 32°C

**Table 7**

| (more inks) | | | | |
|---|---|---|---|---|
| | Tack, gm | Water Balance Avg. % retained | Reactivity, mJ/cm² 1-400 watts/in lamp | |
| Comp M | 12.5 | 24.2 | 275 | |
| Inks using Ex 11 | | | 10% | 12% |
| Black | 12.3 | 19.2 | 295 | 95 |
| Cyan | 12.9 | 26.8 | 296 | 76 |
| Inks using Ex 12 | | | 10% | 12% |
| Black | 13.9 | 20.4 | 108 | 296 |
| Magenta | 14.5 | 29.6 | 209 | 282 |
| Cyan | 13.2 | 26.8 | 522 | 70 |

Inks using 10% of the photo-initiator blend of Example 11 exhibited reactivities comparable to the Comp M. Increasing the photo-initiator level to 12% caused a 71% increase (on average) in reactivity for the black and cyan inks. Inks using the photo-initiator blend of Example 12 exhibited significant reactivity increases with the black and magenta inks compared to Comp M, however the cyan ink exhibited very slow reactivity. An increase in the photo-initiator level (to 12%) caused a significant increase in the cyan ink's reactivity.

Ink tacks were similar regardless of photo-initiator. Inks tested with these photo-initiator blends (Ex 11 & 12) did not show adverse effects on fountain solution conductivity (and thus printability) or on water balance or pick-up. Regardless of photo-initiator colored inks tended to retain more water, while black inks tended to retain less. On the basis of reactivity responsiveness, inks made from Example 11 appear to be particularly suitable for lithographic applications.

## Claims

1. A formulation comprising a mixture of three or more photo-initiators, the mixture being a liquid at a temperature at or below ambient; the mixture comprising:
(a) a first photo-initiator comprising an optionally substituted hydroxyC₁₋₁₀ alkylC₆₋₁₈aryl ketone which is liquid at ambient temperature;
(b) a second photo-initiator comprising an optionally substituted hydroxy(cycloC₃₋₁₀alkyl)C₆₋₁₈aryl ketone which is solid at ambient temperature; and
(c) a third photo-initiator comprising an optionally substituted C₆₋₁₈aryl(((C₁₋₁₀ alkyl)₁₋₄C₆₋₁₈arylcarbonyl))₁₋₃ phosphine oxide which is solid at ambient temperature;
where
(i) the first photo-initiator (a) and the second photo-initiator (b) are present in the mixture in a weight ratio of from about 0.8 to about 1.2,
(ii) the first photo-initiator (a) and the second photo-initiator (b) together comprise at least about 60% by weight of the total mixture; and
(iii) the third photo-initiator (c) comprises at least about 25 % by weight of the total mixture.

2. A formulation as claimed in claim 1, in which the first photo-initiator (a) comprises a hydroxyC₁₋₆alkylC₆₋₁₂aryl ketone.

3. A formulation as claimed in claim 2, in which the first photo-initiator (a) comprises a hydroxyC₁₋₄ alkylphenyl ketone.

4. A formulation as claimed in claim 3, in which the first photo-initiator (a) comprises 2-hydroxy-2-methyl-1 -phenyl-1 -propanone.

5. A formulation as claimed in claim 1, in which the second photo-initiator (b) comprises a hydroxy(cycloC₃₋₆alkyl)C₆₋₁₂aryl ketone.

6. A formulation as claimed in claim 5, in which the second photo-initiator (b) comprises a hydroxy(cycloC₃₋₆alkyl)phenyl ketone.

7. A formulation as claimed in claim 6, in which the second photo-initiator (b) comprises 1-hydroxycyclohexyl phenyl ketone.

8. A formulation as claimed in claim 1, in which the third photo-initiator (c) comprises a C₆₋₁₂aryl(((C₁₋₆alkyl)₂₋₃C₆₋₁₂arylcarbonyl))₁₋₂ phosphine oxide.

9. A formulation as claimed in claim 8, in which the third photo-initiator (c) comprises a phenyl((C₁₋₄alkyl)₃benzoyl)₂ phosphine oxide;

10. A formulation as claimed in claim 9, in which the third photo-initiator (c) comprises phenyl bis(2,4,6-trimethyl benzoyl) phosphine oxide.

11. A formulation as claimed in any preceding claim, in which the weight ratio of the first photo-initiator (a) to the second photo-initiator (b) is from about 0.9 to about 1.1.

12. A formulation as claimed in claim 11, in which the weight ratio of the first photo-initiator (a) to the second photo-initiator (b) is about 1.0.

13. A formulation as claimed in any preceding claim, in which the first photo-initiator (a) and the second photo-initiator (b) together comprise from about 60% to about 75% by weight of the total mixture.

14. A formulation as claimed in any preceding claim, in which the third photo-initiator (c) comprises from about 25% to about 40% by weight of the total mixture.

15. A process comprising the steps of mixing together
(a) a first photo-initiator comprising an optionally substituted hydroxyC₁₋₁₀ alkylC₆₋₁₈aryl ketone which is liquid at ambient temperature;
(b) a second photo-initiator comprising an optionally substituted hydroxy(cycloC₃₋₁₀alkyl)C₆₋₁₈aryl ketone which is solid at ambient temperature; and
(c) a third photo-initiator comprising an optionally substituted C₆₋₁₈aryl(((C₁₋₁₀ alkyl)₁₋₄C₆₋₁₈arylcarbonyl))₁₋₃ phosphine oxide which is solid at ambient temperature;
where
(i) the first photo-initiator (a) and the second photo-initiator (b) are present in the mixture in a weight ratio of from about 0.8 to about 1.2,
(ii) the first photo-initiator (a) and the second photo-initiator (b) together comprise at least about 60% by weight of the total mixture; and
(iii) the third photo-initiator (c) comprises at least about 25 % by weight of the total mixture. to form mixture of three or more photo-initiators, said mixture being a liquid at a temperature at or below ambient.

16. A formulation obtained and/or obtainable by a process as claimed in claim 15.

17. A method of preparing an ink comprising the steps of mixing a formulation as claimed in any of claims 1 to 14 or 16; with a suitable carrier medium and/or colorant.

18. An ink obtained and/or obtainable by a process as claimed in claim 17.
